**Europäisches Patentamt**

**European Patent Office**

**Office européen des brevets**

(19)

(11) Publication number: **0 068 892**

**B1**

(12) **EUROPEAN PATENT SPECIFICATION**

(45) Date of publication of patent specification: **27.04.88**

(21) Application number: **82303412.9**

(22) Date of filing: **29.06.82**

(51) Int. Cl.⁴: **G 11 C 8/00, H 03 K 19/017**

(54) Inverter circuit.

(30) Priority: **29.06.81 JP 99746/81**

(43) Date of publication of application:
**05.01.83 Bulletin 83/01**

(45) Publication of the grant of the patent:
**27.04.88 Bulletin 88/17**

(84) Designated Contracting States:
**DE FR GB**

(56) References cited:
**US-A-4 069 430**

**PATENTS ABSTRACTS OF JAPAN, vol. 1, no. 123, 14th October 1977, page 5142E77**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**5-9-301, 1-20, Utsukushigaoka Midori-ku**
**Yokohama-shi Kanagawa 227 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

# Description

The present invention relates to an inverter circuit which is, for example, used as an output stage of a word driver in metal-oxide semiconductor (MOS) memory devices.

In recent years, in MOS (broadly, metal-insulated semiconductor (MIS)) memory devices, the potential of a power supply has been gradually decreased. Therefore, if a signal having a particularly high potential is required, such a high potential signal is generated by using a charge-pumping circuit or the like. For example, such a high-potential signal is supplied as a clock signal to an inverter circuit which serves as an output stage of a word driver in MOS memory devices.

One prior art inverter circuit comprises two MOS transistors: a load transistor on the side of a high-potential power supply and a driving transistor on the side of a low-potential power supply. In this case, the two transistors are connected in series between the high- and low-potential power supplies. Two clock signals, which are approximately opposite in phase, are supplied to the gates of the two transistors, respectively, while the connection node between the two transistors serves as an output terminal of the inverter circuit.

In the above-mentioned prior art inverter circuit, however, when the load transistor and the driving transistor are in an off state and an on state, respectively, the potential at the connection node is low. Therefore, a high potential is applied directly to the load transistor, which, in turn, operates in a deep saturation region. As a result, a large amount of hot electrons and hot holes having high energy are generated and captured by a gate oxide layer so that the electrical characteristics, such as the threshold voltage ($V_{th}$) value, of the load transistor fluctuate. In addition, since the load transistor operates in a state near to a punch-through state during the conduction mode in the deep saturation region, the load transistor may break down.

Similarly, when the load transistor and the driving transistor are in an on state and an off state, respectively, the potential at the connection node is high. Therefore, a high potential is also applied directly to the driving transistor, which, in turn, operates in a deep saturation region. Therefore, the above-mentioned dangers also exist with respect to the driving transistor.

It is, therefore, desirable to provide an inverter circuit having a load transistor and a driving transistor connected in series, in which both of the transistors can be operated in a shallow saturation region, thereby avoiding fluctuation of the electrical characteristics, such as threshold voltage ($V_{th}$) values, of these transistors and the breakdown of these transistors.

According to the present invention, there is provided an inverter circuit comprising: a low-potential power supply line; first and second high-potential power supply lines, the second of which is maintained at a higher potential than the first when the circuit is in use; a driving MIS transistor connected in series with a load MIS transistor and a further MIS transistor between the low-potential power supply line and the said second high-potential power supply line so that the said further transistor is between the load transistor and the second high-potential power supply line and so that the driving transistor is between the low-potential power supply line and an output node of the circuit, which node is between the driving and load transistors; clock signal generating means connected to respective gates of the load and driving transistors for applying thereto respectively first and second clock signals, which are substantially opposite in phase, the high-potential value of the said first clock signal being higher than the operating potential of the second high-potential power supply line; and means comprising a capacitor, connected at one electrode thereof to a gate of the said further transistor, and also comprising an auxiliary MIS transistor, having a gate connected to the said first high-potential power supply line and having a source connected to the said gate of the further transistor, the said means being operative to raise the potential of that gate to a value higher than that of the said second high-potential power supply line when the driving transistor is rendered non-conductive by the said second clock signal; characterised in that an additional MIS transistor is connected in series with the driving and load transistors, between the driving transistor and the said output node, and has a gate connected so that the additional transistor is conductive when the driving transistor is conductive and is non-conductive when the driving transistor is non-conductive; and in that the said auxiliary MIS transistor has a drain connected to the said first high-potential power supply line.

JP—A—5255465 discloses an inverter circuit in accordance with that portion of the last preceding paragraph which precedes the words "characterised in that". However, in so far as the presence of a further MIS transistor may provide protection for the load MIS transistor in this prior art circuitry, such protection is purely fortuitous since this prior art document is concerned only with lowering power consumption and attaining high response capability. Further, this prior art circuitry does not employ a power supply line having a particularly high potential and thus would not be subject to the same problem with which the present invention is intended to deal. This prior art document shows no appreciation or indication of the problem with which the present invention is concerned, and accordingly does not show or suggest another transistor, or any other means, for protecting the driving MIS transistor.

Reference will now be made, by way of example, to the accompanying drawings, wherein:

Figure 1 is a circuit diagram of a prior art inverter circuit;

Fig. 2 is a timing diagram of signals appearing in the circuit of Fig. 1;

Fig. 3 is a circuit diagram of circuitry for an embodiment of the present invention;

Fig. 4 is a timing diagram of signals appearing in the circuitry of Fig. 3;

Fig. 5 is a circuit diagram of circuitry for another embodiment of the present invention;

Fig. 6 is a circuit diagram of circuitry including the circuit of Fig. 3; and

Fig. 7 is a timing diagram of signals appearing in the circuitry of Fig. 6.

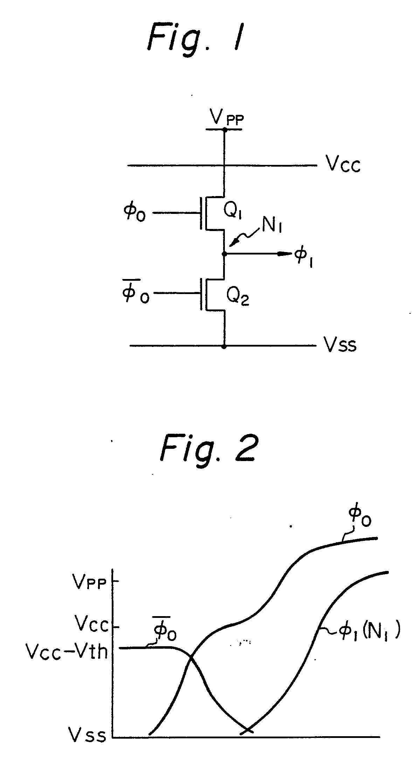

First, one prior art inverter circuit will be explained with reference to Figs. 1 and 2. In Fig. 1, $V_{SS}$, $V_{CC}$, and $V_{PP}$ are power supplies. In this case, $V_{SS}$, $V_{CC}$, and $V_{PP}$ indicate also the potential values of the power supplies $V_{SS}$, $V_{CC}$, and $V_{PP}$, respectively. In more detail, the potential $V_{SS}$ is low while the potential $V_{CC}$ is high. Further, the potential $V_{PP}$ is higher than the potential $V_{CC}$. For example, the potential $V_{PP}$ is generated by a charge-pumping circuit or the like.

The inverter circuit of Fig. 1 comprises a load MIS transistor $Q_1$ and a driving transistor $Q_2$ connected in series between the power supply $V_{SS}$ and the power supply $V_{PP}$. A clock signal $\phi_0$ and an inverse clock signal $\overline{\phi_0}$, which is approximately opposite in phase to $\phi_0$, are supplied to the gates of the transistors $Q_1$ and $Q_2$, respectively, and an output signal $\phi_1$ is obtained at the connection node of the two transistors. In this case, the high-level potential of the signal $\phi_0$ is set at a higher value than the power supply potential $V_{PP}$ by using the bootstrap effect or the like. Therefore, the high-level potential of the output signal $\phi_1$ becomes the same as the power supply potential $V_{PP}$.

The operation of the circuit of Fig. 1 will be explained with reference to Fig. 2. Note that $V_{th}$ indicates a common threshold voltage of the transistors. When the potentials of the clock signals $\phi_0$ and $\overline{\phi_0}$ are low ($V_{SS}$) and high ($V_{CC}$—$V_{th}$), respectively, the transistors $Q_1$ and $Q_2$ are in an off state and an on state, respectively, so that the potential of the output signal $\phi_1$ is low ($V_{SS}$). Next, when the potential of the signal $\phi_0$ is changed from low ($V_{SS}$) to high ($>V_{PP}$) and, simultaneously, the potential of the signal $\overline{\phi_0}$ is changed from high ($V_{CC}$—$V_{th}$) to low ($V_{SS}$), the transistors $Q_1$ and $Q_2$ change to an on state and an off state, respectively. As a result, the potential of the output signal $\phi_1$ increases. In this case, since the potential of the signal $\phi_0$ is set at a higher value than $V_{PP}$ by using the bootstrap effect or the like, the potential of the output signal $\phi_1$ is pulled up to the high power supply potential $V_{PP}$, as illustrated in Fig. 2.

In Fig. 1, however, when the potential of each of the signals $\phi_0$ and $\overline{\phi_0}$ remains low ($V_{SS}$) and high ($V_{CC}$—$V_{th}$), respectively, a large difference $V_{PP}$ in potential is applied between the drain and source of the load transistor $Q_1$, which causes the transistor $Q_1$ to be operated in a deep saturation region. Therefore, as explained above, the electrical characteristics, such as the threshold voltage ($V_{th}$) value, of the load transistor $Q_1$ may fluctuate, and, in addition, breakdown of the load transistor

$Q_1$ may occur. Similarly, when the potential of each of the signals $\phi_0$ and $\overline{\phi_0}$ remains high ($>V_{PP}$) and low ($V_{SS}$), respectively, a large difference $V_{PP}$ in potential is applied between the drain and source of the driving transistor $Q_2$. Therefore, the above-mentioned phenomena can also occur in the driving transistor $Q_2$.

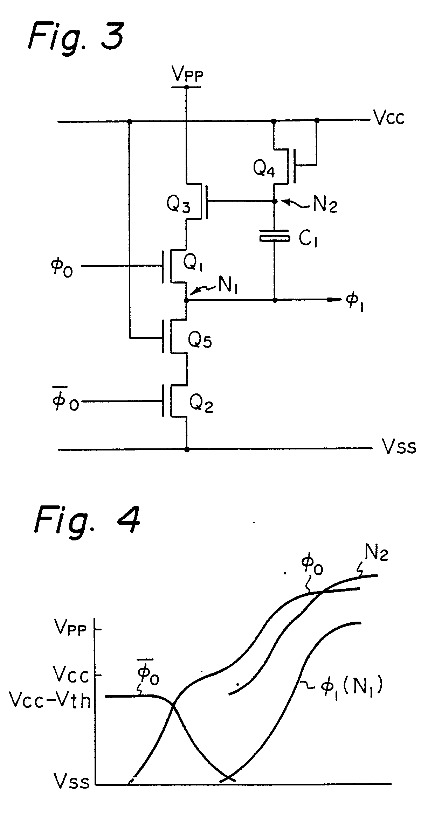

Figure 3 is a circuit diagram of an inverter circuit. In Fig. 3, the transistors $Q_3$, $Q_4$, and $Q_5$ and a capacitor $C_1$ are added to the elements of Fig. 1. Note that the transistor $Q_4$ and the capacitor $C_1$ form a bootstrap circuit.

By the addition of the transistor $Q_3$, when the signals $\phi_0$ and $\overline{\phi_0}$ are low ($V_{SS}$) and high ($V_{CC}$—$V_{th}$), respectively, the large difference $V_{PP}$ in potential is divided by the two transistors $Q_1$ and $Q_3$, thereby reducing the load of the load transistor $Q_1$ as compared with the Fig. 1 circuit. By the addition of the transistor $Q_5$, when the signals $\phi_0$ and $\overline{\phi_0}$ are high ($>V_{PP}$) and low ($V_{SS}$), respectively, the large difference $V_{PP}$ in potential is divided by the two transistors $Q_2$ and $Q_5$, thereby reducing the load of the driving transistor $Q_2$ as compared with the Fig. 1 circuit.

The operation of the circuit of Fig. 3 will be explained with reference to Fig. 4. When the potentials of the signals $\phi_0$ and $\overline{\phi_0}$ are low ($V_{SS}$) and high ($V_{CC}$—$V_{th}$), respectively, the transistors $Q_1$ and $Q_2$ are in an off state and an on state, respectively, so that the potential at the node $N_1$, that is, the potential of the output signal $\phi_1$, becomes low ($V_{SS}$). Simultaneously, current flows from the power supply $V_{CC}$ through the transistor $Q_4$ to the node $N_2$ so that the capacitor $C_1$ is charged. In this case, the potential at the node $N_2$ equals $V_{CC}$—$V_{th}$. Note that, in this state, the large difference $V_{PP}$ in potential is divided by the two transistors $Q_1$ and $Q_3$, and, accordingly, the drain-source voltage of the load transistor $Q_1$ is decreased as compared with the Fig. 1 circuit.

Next, when the potential of the signal $\phi_0$ is changed from low ($V_{SS}$) to high ($>V_{PP}$) and, in addition, the signal $\overline{\phi_0}$ is changed from high ($V_{CC}$—$V_{th}$) to low, ($V_{SS}$) the transistors $Q_1$ and $Q_2$ change to an on state and an off state, respectively, and, simultaneously, the transistor $Q_3$ changes to an on state due to the high potential at the node $N_2$. Therefore, current flows from the power supply $V_{PP}$ through the transistors $Q_3$ and $Q_1$ to the node $N_1$, which, in turn, increases the potential of the node $N_1$. At this time, since the transistor $Q_4$ is cut off due to the fact that the gate-source voltage of the transistor $Q_4$ is less than the threshold voltage ($V_{th}$) value thereof, the potential at the node $N_2$ increases as the potential at the node $N_1$ increases. Therefore, the potential at the node $N_2$ becomes higher than the potential $V_{CC}$ and, finally, this potential becomes substantially higher than the potential $V_{PP}$. Such pushing up of the potential at the node $N_2$ is called the bootstrap effect. Thus, since a substantially higher potential than the potential $V_{PP}$ is applied to the gates $Q_3$ and $Q_1$, the potential at the node $N_1$, that is, the potential of the output signal $\phi_1$, equals the potential $V_{PP}$. Note that, even in this state, the

large difference $V_{PP}$ in potential is divided by the two transistors $Q_2$ and $Q_5$, and, accordingly, the drain-source voltage of the driving transistor $Q_2$ is decreased as compared with the Fig. 1 circuit.

The output waveform of the inverter circuit of Fig. 3 is about the same as the output waveform of the circuit of Fig. 1.

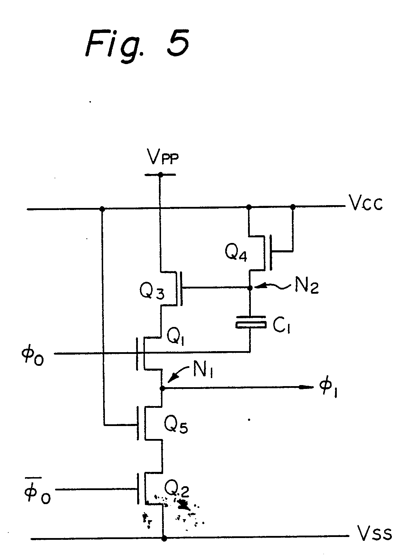

Figure 5 is a circuit diagram of another inverter circuit. In Fig. 5, the capacitor $C_1$ is connected to the gate of the load transistor $Q_1$, not to the node $N_1$. Therefore, in this case, the potential at the node $N_2$ is pushed up by the increase of the potential of the signal $\phi_0$ so as to cause the bootstrap effect.

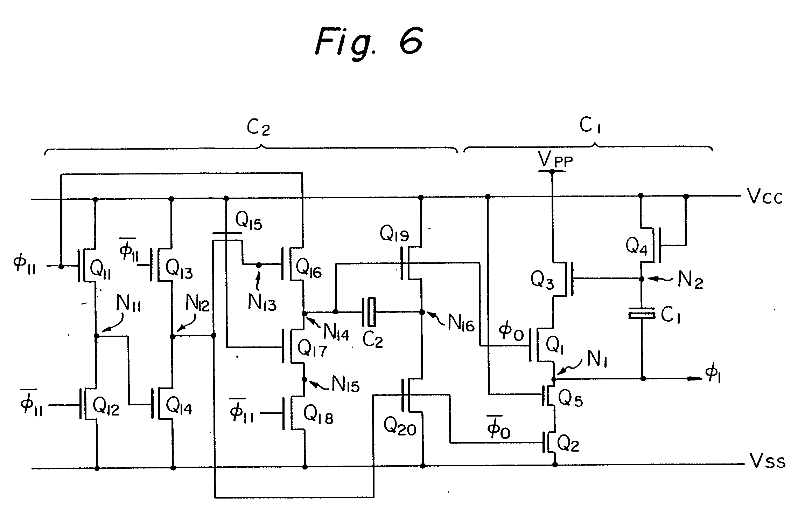

Figure 6 is a circuit diagram in which the circuit of Fig. 3 is applied to a word driver circuit for generating a word line driving signal. In Fig. 6, $C_1$ indicates the circuit of Fig. 3, and $C_2$ is a circuit for generating the clock signals $\phi_0$ and $\overline{\phi_0}$.

In the circuit $C_2$, the transistors $Q_{11}$ and $Q_{12}$ constitute an inverter which is operated by receiving clock signals $\phi_{11}$ and $\overline{\phi_{11}}$ which are opposite in phase. The transistors $Q_{13}$ and $Q_{14}$ also constitute an inverter circuit which is operated by receiving the clock signal $\overline{\phi_{11}}$ and the potential at the node $N_{11}$ of the pre-stage inverter circuit. A transistor $Q_{15}$ is interposed between the second stage inverter circuit and a bootstrap circuit. This bootstrap circuit is formed by the transistors $Q_{16}$ through $Q_{20}$ and a capacitor $C_2$. Among them, the transistor $Q_{17}$ is used to protect the transistor $Q_{18}$ when the bootstrap potential node $N_{14}$ is discharged. That is, when the bootstrap potential at the node $N_{14}$ is particularly high, such high potential is divided by the two transistors $Q_{17}$, and $Q_{18}$, thereby reducing the drain-source voltage of the transistor $Q_{18}$.

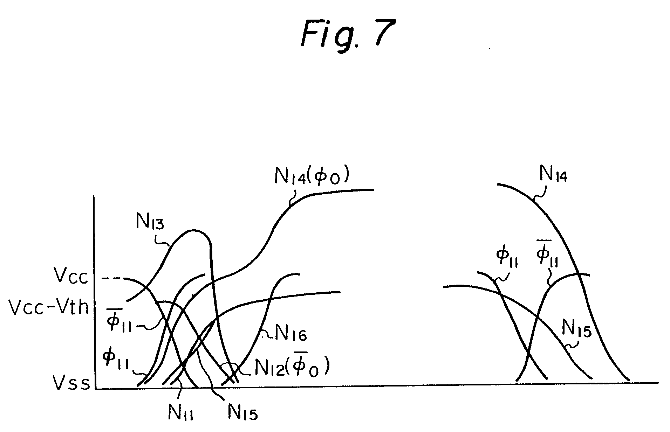

The operation of the circuit of Fig. 6 will now be explained with reference to Fig. 7. First, when the potentials of the clock signals $\phi_{11}$ and $\overline{\phi_{11}}$ are low ($V_{SS}$) and high ($V_{CC}$), respectively, the transistors $Q_{12}$ and $Q_{13}$ are in an on state so that the potentials at the nodes $N_{11}$ and $N_{12}$ are low ($V_{SS}$) and high ($V_{CC}-V_{th}$), respectively. In addition, since the transistor $Q_{15}$ is in an on state, the node $N_{13}$ is charged up to the potential $V_{CC}-V_{th}$. Next, when the potentials of the signals $\phi_{11}$ and $\overline{\phi_{11}}$ become high ($V_{CC}$) and low ($V_{SS}$), respectively, the transistors $Q_{11}$ and $Q_{12}$ turn on and off, respectively. Therefore, the potential at the node $N_{11}$ becomes high, and, accordingly, the transistor $Q_{14}$ turns on so that the potential at the node $N_{12}$ becomes low since the transistor $Q_{13}$ has already turned off. Thus, after the potential of the signal $\phi_{11}$ becomes high ($V_{CC}$), the potential at the node $N_{12}$ is changed from high ($V_{CC}-V_{th}$) to low ($V_{SS}$) with some delay. In addition, the node $N_{14}$ is charged by the signal $\phi_{11}$. In this case, the discharging of the node $N_{12}$ is carried out later than the charging of the node $N_{14}$. Therefore, the node $N_{13}$ is discharged by the transistor $Q_{15}$, which cuts off the transistor $Q_{16}$. Thus, at this time, the node $N_{14}$ changes to a floating state. Simultaneously, the transistor $Q_{20}$ is cut off so that the potential at the node $N_{16}$ changes from

low ($V_{SS}$) to high ($V_{CC}$). As a result, the potential at the node $N_{14}$ is pushed up to a potential level higher than the potential $V_{CC}$ by the capacitive coupling of the capacitor $C_2$. Thus, a potential which is significantly higher than the potential $V_{CC}$ is obtained at the node $N_{14}$. Note that such a particularly high potential at the node $N_{14}$ is divided by the transistors $Q_{17}$ and $Q_{18}$, thereby reducing the load of the transistor $Q_{18}$. Next, when the signals $\phi_{11}$ and $\overline{\phi_{11}}$ and reversed, the transistor $Q_{18}$ turns on, and, as a result, the charges stored at the node $N_{14}$ are discharged through the on-state transistors $Q_{17}$ and $Q_{18}$.

In the above-mentioned embodiments, only the transistor $Q_3$ (or $Q_5$) is connected in series to the transistor $Q_1$ (or $Q_2$); however, two or more transistors can be connected in series to the transistor $Q_1$ (or $Q_2$).

**Claims**

1. An inverter circuit comprising:
a low-potential power supply line ($V_{SS}$),
first and second high-potential power supply lines ($V_{CC}$, $V_{PP}$), the second of which is maintained at a higher potential than the first when the circuit is in use,
a driving MIS transistor ($Q_2$) connected in series with a load MIS transistor ($Q_1$) and a further MIS transistor ($Q_3$) between the low-potential power supply line ($V_{SS}$) and the said second high-potential power supply line ($V_{PP}$) so that the said further transistor ($Q_3$) is between the load transistor ($Q_1$) and the second high-potential power supply line and so that the driving transistor ($Q_2$) is between the low-potential power supply line ($V_{SS}$) and an output node ($N_1$) of the circuit, which node is between the driving and load transistors ($Q_2$, $Q_1$),
clock signal generating means connected to respective gates of the load and driving transistors ($Q_1$, $Q_2$) for applying thereto respectively first and second clock signals ($\phi_0$, $\overline{\phi_0}$), which are substantially opposite in phase, the high-potential value of the said first clock signal ($\phi_0$) being higher than the operating potential of the second high-potential power supply line ($V_{PP}$),
and means ($C_1$, $Q_4$) comprising a capacitor ($C_1$), connected at one electrode thereof to a gate of the said further transistor ($Q_3$), and also comprising an auxiliary MIS transistor ($Q_4$), having a gate connected to the said first high-potential power supply line ($V_{CC}$) and having a source connected to the said gate of the further transistor ($Q_3$), the said means ($C_1$, $Q_4$) being operative to raise the potential of that gate to a value higher than that of the said second high-potential power supply line ($V_{PP}$) when the driving transistor ($Q_2$) is rendered non-conductive by the said second clock signal ($\phi_0$);
characterised in that an additional MIS transistor ($Q_5$) is connected in series with the driving and load transistors ($Q_2$, $Q_1$), between the driving transistor ($Q_2$) and the said output node ($N_1$), and has a gate connected so that the additional transistor ($Q_5$) is conductive when the driving

transistor ($Q_2$) is conductive and is non-conductive when the driving transistor ($Q_2$) is non-conductive; and in that the said auxiliary MIS transistor ($Q_4$) has a drain connected to the said first high-potential power supply line ($V_{CC}$.

2. A circuit as claimed in claim 1, wherein the other electrode of the said capacitor ($C_1$) is connected to the said output node ($N_1$).

3. A circuit as claimed in claim 1, wherein the other electrode of the said capacitor ($C_1$) is connected to the gate of the said load MIS transistor ($Q_1$).

4. A circuit as claimed in any preceding claim, wherein the said first and second clock signals ($\phi_0$, $\overline{\phi}_0$) are derived by the said clock signal generating means from the potential difference between the said low-potential power supply line ($V_{SS}$) and the said first high-potential power supply line ($V_{CC}$).

## Patentansprüche

1. Inverterschaltung mit:
einer Niedrigpotential-Energieversorgungsleitung ($V_{SS}$),
ersten und zweiten Hochpotential-Energieversorgungsleitungen ($V_{CC}$, $V_{PP}$), von denen die zweite auf einem höheren Potential als die erste gehalten wird, wenn die Schaltung in Betrieb ist,
einem Treiber-MIS-Transistor ($Q_2$), der mit einem Last-MIS-Transistor ($Q_1$) in Reihe geschaltet ist, und einem weiteren MIS-Transistor ($Q_3$) zwischen der Niedrigpotential-Energieversorgungsleitung ($V_{SS}$) und der genannten Hochpotential-Energieversorgungsleitung ($V_{PP}$), so daß der genannte weitere Transistor ($Q_3$) zwischen dem Lasttransistor ($Q_1$) und der zweiten Hochpotential-Energieversorgungsleitung liegt, und so, daß der Treibertransistor ($Q_2$) zwischen der Niedrigpotential-Energieversorgungsleitung ($V_{SS}$) und einem Ausgangsknoten ($N_1$) der Schaltung liegt, welcher Knoten zwischen dem Treibertransistor und dem Lasttransistor ($Q_2$, $Q_1$) liegt,
Taktsignalgeneratoreinrichtungen, welche mit den jeweiligen Gates des Lasttransistors und des Treibertransistors ($Q_1$, $Q_2$) verbunden sind, um ihnen entsprechende erste und zweite Taktsignale ($\phi_0$, $\overline{\phi}_0$) zuzuführen, die im wesentlichen entgegengesetzte Phase haben, wobei der Hochpotentialwert des genannten ersten Taktsignals ($\phi_0$) höher als das Betriebspotential der zweiten Hochpotential-Energieversorgungsleitung ($V_{PP}$) ist,
und eine Einrichtung ($C_1$, $Q_4$), die einen Kondensator ($C_1$) umfaßt, der mit seiner einen Elektrode mit einem Gate des genannten weiteren Transistors ($Q_3$) verbunden ist, und auch einen Hilfs-MIS-Transistor ($Q_4$) umfaßt, der ein Gate hat, das mit der genannten ersten Hochpotential-Energieversorgungsleitung ($V_{CC}$) verbunden ist, und eine Source hat, die mit dem genannten Gate des weiteren Transistors ($Q_3$) verbunden ist, wobei die genannte Einrichtung ($C_1$, $Q_4$) betreibbar ist, um das Potential von jenem Gate auf einen Wert höher als denjenigen der genannten zweiten Hochpotential-Energieversorgungsleitung ($V_{PP}$)

anzuheben, wenn der Treibertransistor ($Q_2$) durch das genannte zweite Taktsignal ($\phi_0$) nichtleitend gemacht wird;
dadurch gekennzeichnet, daß ein zusätzlicher MIS-Transistor ($Q_5$) in Reihe mit dem Treibertransistor und dem Lasttransistor ($Q_2$, $Q_1$) zwischen dem Treibertransistor ($Q_2$) und dem genannten Ausgangsknoten ($N_1$) verbunden ist, und ein Gate hat, das so angeschlossen ist, daß der zusätzliche Transistor ($Q_5$) leitend ist, wenn der Treibertransistor ($Q_2$) leitend ist, und nichtleitend ist, wenn der Treibertransistor ($Q_2$) nichtleitend ist, und daß der genannte Hilfs-MIS-Transistor ($Q_4$) ein Drain hat, das mit der genannten ersten Hochpotential-Energieversorgungsleitung ($V_{CC}$) verbunden ist.

2. Schaltung nach Anspruch 1, bei der die andere Elektrode des genannten Kondensators ($C_1$) mit dem genannten Ausgangsknoten ($N_1$) verbunden ist.

3. Schaltung nach Anspruch 1, bei der die andere Elektrode des genannten Kondensators ($C_1$) mit dem Gate des genannten Last-MIS-transistors ($Q_1$) verbunden ist.

4. Schaltung nach einem der vorhergehenden Ansprüche, bei der das genannte erste und zweite Taktsignal ($\phi_0$, $\overline{\phi}_0$) durch die genannte Taktsignalgeneratoreinrichtung aus der Potentialdifferenz zwischen der genannten Niedrigpotential-Energieversorgungsleitung ($V_{SS}$) und der genannten ersten Hochpotential-Energieversorgungsleitung ($V_{CC}$) abgeleitet wird.

## Revendications

1. Circuit inverseur comportant:
une ligne d'alimentation de potentiel bas ($V_{SS}$),
une première et une seconde ligne d'alimentation de potentiel haut ($V_{CC}$), ($V_{PP}$), dont la seconde est maintenue à un potentiel supérieur à celui de la première quand le circuit est en utilisation,
un transistor MIS d'attaque ($Q_2$) connecté en série avec un transistor MIS de charge ($Q_1$) et un autre transistor MIS ($Q_3$) entre la ligne d'alimentation de potentiel bas ($V_{SS}$) et ladite second ligne d'alimentation de potentiel haut ($V_{PP}$) de manière que ledit autre transistor ($Q_3$) se trouve entre le transistor de charge ($Q_1$) et la seconde ligne d'alimentation de potentiel haut, et de manière que le transistor d'attaque ($Q_2$) se trouve entre la ligne d'alimentation de potentiel bas ($V_{SS}$) et un point commun de sortie ($N_1$) du circuit, ce point commun se trouvant entre les transistors d'attaque et de charge ($Q_2$, $Q_1$),
un dispositif générateur de signal d'horloge connecté aux grilles respectives des transistors de charge et d'attaque ($Q_1$, $Q_2$) pour leur appliquer respectivement un premier et un second signal d'horloge ($\phi_0$, $\overline{\phi}_0$) dont les phases sont pratiquement opposées, la valeur de potentiel haut dudit premier signal d'horloge ($\phi_0$) étant supérieure à celle du potentiel d'alimentation de la second ligne d'alimentation de potentiel haut ($V_{PP}$)
et un dispositif ($C_1$, $Q_4$) comprenant un condensateur ($C_1$) connecté par une électrode à une grille dudit autre transistor ($Q_3$) et comportant également-

ment un transistor MIS auxiliaire ($Q_4$) done une grille est connecté à ladite première ligne d'alimentation de potentiel haut ($V_{cc}$) et dont une source est connectée à ladite grille de l'autre transistor ($Q_3$), ledit dispositif ($C_1$, $Q_4$) ayant pour fonction d'augmenter le potentiel à cette grille jusqu'à une valeur supérieure à celle de ladite seconde ligne d'alimentation de potentiel haut ($V_{pp}$) quand le transistor d'attaque ($Q_2$) est rendu non conducteur par ledit second signal d'horloge ($\phi_0$);

caractérisé en ce qu'un transistor MIS supplémentaire ($Q_5$) est connecté en série avec les transistors d'attaque et de charge ($Q_2$, $Q_1$) entre le transistor d'attaque ($Q_2$) et ledit point commun de sortie ($N_1$) et comporte une grille connectée de manière que le transistor supplémentaire ($Q_1$) soit conducteur quand le transistor d'attaque ($Q_2$) est conducteur et soit non conducteur quand le transistor d'attaque ($Q_2$) est non conducteur; et en ce que ledit transistor MIS auxiliaire ($Q_4$) comporte un drain connecté à ladite première ligne d'alimentation de potentiel haut ($V_{cc}$).

2. Circuit selon la revendication 1, dans lequel l'autre électrode dudit condensateur ($C_1$) est connectée audit point commun de sortie ($N_1$).

3. Circuit selon la revendication 1, dans lequel l'autre électrode dudit condensateur ($C_1$) est connectée à la grille dudit transistor MIS de charge ($Q_1$).

4. Circuit selon l'une quelconque des revendications précédentes, dans lequel ledit premier et ledit second signal d'horloge ($\phi_0$, $\overline{\phi_0}$) sont dérivés par ledit dispositif générateur de signal d'horloge de la différence de potentiel entre ladite ligne d'alimentation de potentiel bas ($V_{SS}$) et ladite première ligne d'alimentation de potentiel haut ($V_{cc}$).

## Fig. 1

$V_{PP}$

$V_{CC}$

$\phi_0$ — $Q_1$ — $N_1$ → $\phi_1$

$\overline{\phi}_0$ — $Q_2$

$V_{SS}$

## Fig. 2

$V_{PP}$

$V_{CC}$

$V_{CC} - V_{th}$

$\overline{\phi}_0$

$\phi_0$

$\phi_1 (N_1)$

$V_{SS}$

1

# Fig. 3

# Fig. 4

# Fig. 5

# Fig. 6

# Fig. 7